Europäisches Patentamt

European Patent Office

Office européen des brevets

(19)

(11) Publication number: **0 260 875 B1**

# EUROPEAN PATENT SPECIFICATION

(12)

(45) Date of publication of patent specification: **24.06.92** (51) Int. Cl.⁵: **C04B 35/49**, H01L 37/02

(21) Application number: **87307983.4**

(22) Date of filing: **09.09.87**

(54) **Ceramic composition for pyroelectric sensors.**

(30) Priority: **12.09.86 JP 216745/86**

(43) Date of publication of application:
**23.03.88 Bulletin 88/12**

(45) Publication of the grant of the patent:
**24.06.92 Bulletin 92/26**

(84) Designated Contracting States:
**DE FR GB NL**

(56) References cited:

**JOURNAL OF MATERIALS SCIENCE LETTERS, vol. 3, no. 8, August 1984, pages 733-738, Chapman and Hall, Ltd, London, GB; M.M. ABOU SEKKINA et al.: "Pyroelectricity and mechano-dielectricity of lead zirconate titanate niobate [Pb(1-y/2)(Zr1-(x+y)TixNby)O3] ceramic transducers"**

(73) Proprietor: **SUMITOMO SPECIAL METAL CO., LTD.**
**22, Kitahama 5-chome Higashi-ku**
**Osaka-shi Osaka 541(JP)**

(72) Inventor: **Fujii, Hiromitsu Yamazaki Seisakusho**
**Sumitomo Special Metal Co.Ltd. 15-17**
**2-chome Egawa**
**Mishima-gun Osaka(JP)**

(74) Representative: **Livsey, Gilbert Charlesworth Norris et al**
**HYDE, HEIDE & O'DONNELL 10-12 Priests Bridge**
**London SW15 5JE(GB)**

EP 0 260 875 B1

**Description**

This invention relates to a ceramic composition having pyroelectricity which a ceramic material produced by firing in a customary way exhibits if it is electrically activated by the application of a polarizing electric field. More particularly, it is a ceramic composition for a pyroelectric sensor which is greatly improved in pyroelectric characteristics, such as a pyroelectric coefficient and a figure of merit, and can be produced at a low cost.

A pyroelectric sensor is a device which is based on the pyroelectricity of certain dielectrics showing spontaneous polarization varying with temperature. Typical applications thereof include temperature measuring instruments of the non-contact type, thermographs, and intrusion alarms.

There are known various kinds of materials for making pyroelectric sensors. They include triglycine sulfate (TGS) crystals, SBN ($Sr_xBa_{1-x}Nb_2O_6$) crystals, lead titanate ceramics, PVDF (polyvinylidene difluoride) polymers, and $LiTaO_3$ crystals. These materials have, however, not always been satisfactory in pyroelectric properties. Moreover, they have presented a variety of problems, including difficulty of handling, as will hereinafter be pointed out.

Triglycine sulfate and SBN crystals have so low a Curie point that they are difficult to polarize. Moreover, they have so narrow a range of working temperatures that they are useful only for a limited scope of application.

Lead titanate ceramics have a high Curie point and therefore require a high polarizing temperature which makes their polarization difficult. Moreover, it is not easy to obtain a ceramic product from lead titanate, especially one of high density which is satisfactory from the stand-point of mechanical strength.

Both of PVDF polymers and triglycine sulfate crystals are so low in dielectric constants that a device made by using them produces a high level of noise.

A single crystal of $LiTaO_3$ having desired properties is so expensive to prepare that its use results in an expensive pyroelectric sensor.

Some piezoelectric materials of the PZT series have been used to overcome the drawbacks of the materials which have been described above. The pyroelectric characteristics (particularly figures of merit) of these piezoelectric materials are, however, still so poor that there is a strong demand for materials of improved properties.

Under these circumstances, it is an object of this invention to provide a ceramic composition for a pyroelectric sensor which has excellent pyrolectric characteristics, a relatively low polarizing temperature and a high density, can produce a device making only a low level of noise, and can be produced at a low cost.

This object is essentially attained by a ceramic composition comprising $Pb(Zn_{1/3}\bullet Nb_{2/3})O_3$, $Pb(Ni_{1/3}\bullet Nb_{2/3})O_3$, $PbTiO_3$ and $PbZrO_3$.

The composition preferably further contains an oxide of Li, Na, K, etc. which gives it a still higher density, or an oxide of Mn, Cr, etc. which enables it to produce a sensor having a still improved output voltage, or both of those oxides.

More specifically, this invention is a ceramic composition of the formula

$$Pb_A\{(Zn_{1/3}\bullet Nb_{2/3})_W \bullet (Ni_{1/3}\bullet Nb_{2/3})_X \bullet Ti_Y \bullet Zr_Z\}O_3$$

where $0.97 \leq A \leq 1.03$,
$0.015 \leq W \leq 0.18$,
$0 \leq X \leq 0.09$,
$0.05 \leq W + X \leq 0.18$,
$0.24 \leq Y \leq 0.38$, and
$0.54 \leq Z \leq 0.68$
when $W + X + Y + Z = 1$.

According to a preferred aspect of this invention, the composition further contains (a) not more than 2 mol % of at least one of $Li_2O$, $Na_2O$ and $K_2O$, or (b) not more than 3 mol % of at least one of $Mn_3O_4$ and $Cr_2O_3$, or (c) both (a) and (b).

The limitations set to the values of A and W to Z in the formula defining the composition of this invention are essential for the reasons which will hereinafter be stated.

(1) $0.97 \leq A \leq 1.03$:
If A is below 0.97 or above 1.03, the composition will not have any satisfactorily high density.
(2) $0.015 \leq W \leq 0.18$, $0.24 \leq Y \leq 0.38$ and $0.54 \leq Z \leq 0.68$:
If W is above 0.18, Y is above 0.38 and Z is below 0.54, the composition will have so high a relative dielectric constants that it will exhibit a greater piezoelectric effect than its pyroelectric effect. If W is below 0.015, Y is below 0.24 and Z is above 0.68, the composition will lack density and will also fail to exhibit any satisfactory pyroelectric effect.

(3) $0 \leq X \leq 0.09$ and $0.05 \leq W + X \leq 0.18$:

If X is above 0.09, the composition will have a high relative dielectric constants and fail to exhibit any satisfactorily high pyroelectric effect. If the sum of W and X is below 0.05 or above 0.18, the composition will fail to exhibit the intended pyroelectric effect.

The composition may further contain not more than 2 mol % of at least one of $Li_2O$, $Na_2O$ and $K_2O$. The addition of the oxide or oxides improves the density, pyroelectric characteristics and mechanical strength of the composition. If the composition contains more than 2 mol % thereof, however, it will have a lower resistivity and result in a sensor having a lower output voltage.

It may alternatively contain not more than 3 mol % of at least one of $Mn_3O_4$ and $Cr_2O_3$. The addition of the oxide or oxides increases the spontaneous polarization of the composition and thereby enables the realization of a sensor having a high output voltage. If it contains more than 3 mol % thereof, however, it will fail to have any satisfactory density.

Alternatively, it may contain both not more than 2 mol % of at least one of $Li_2O$, $Na_2O$ and $K_2O$, and not more than 3 mol % of at least one of $Mn_3O_4$ and $Cr_2O_3$.

In the event that X is 0 and thereofore $0.05 \leq W \leq 0.18$, the values of Y and Z are preferably selected to fall within the ranges "$0.25 \leq Y \leq 0.38$" and "$0.54 \leq Z \leq 0.65$", respectively, in order to ensure that the composition be satisfactory in density, relative dielectric constants etc.

The ceramic composition of this invention can be manufactured by mixing appropriately the raw materials which have been selected from among PbO, NiO, ZnO, $Nb_2O_3$, $TiO_2$, $ZrO_2$, $Li_2O$, $Na_2O$, $K_2O$, $Mn_3O_4$ and $Cr_2O_3$. It is alternatively possible to employ as the starting materials those compounds which are decomposed to the oxides as hereinabove listed when they are heated, e.g. $Pb_2O_4$ for PbO, $NiCO_3$ for NiO, $CrO_3$ for $Cr_2O_3$ and $Li_2CO_3$ for $Li_2O$. It is also possible to use compounds of those oxides.

Zirconium oxide ($ZrO_2$) often contains a small amount of hafnium, though it may usually not exceed a maximum of 1 mol %. It is, therefore, possible that hafnium atoms may occupy some of the positions of tetravalent metal atoms in the mixed crystal. However, hafnium is not an effective element for the ceramic composition of this invention. Moreover, it is more expensive than zirconium and its use merely adds to the cost of the composition which is produced on an industrial basis. Therefore, this invention does not contemplate the substitution of hafnium for a part of zirconium in the composition, while it ignores the hafnium which may exist in a very small quantity in zirconium.

The invention will now be described more specifically with reference to a wide variety of examples thereof.

## EXAMPLES

Samples of a wide variety of different ceramic compositions, including those embodying this invention, were prepared from the raw materials which had been so weighed as to satisfy the proportional relationship specified by the values of A and W to Z in TABLE 1. The raw materials for each sample were mixed together in a ball mill under wet conditions. After the mixture had been calcined at 850°C for two hours, it was crushed in the ball mill to a powder having a particle diameter of about 1 $\mu$m. The powder was compacted to form a 10 mm cubic shape and the compacted product was subjected to two hours of sintering at a temperature of 1050°C to 1150°C. The sintered product was subjected to compression by a hot isostatic press at a temperature of 1050°C to 1150°C and a pressure of 50,7 to 101 mPa (500 to 1000 atm) and was then heat treated at a temperature of 800°C to 900°C. A silver electrode was attached to each of the opposite faces of each sample and it was polarized in a bath of insulating oil having a temperature of 100°C to 150°C by the application of a DC voltage of 3 to 5 kV/mm. A piece having a thickness of 100 $\mu$m was cut from the sample and after it had been polished, a blackened film of gold was evaporated on one of its surfaces which was adapted for infrared incident ray, while an evaporated film of gold was formed on the other surface thereof. A 5 mm square piece was cut therefrom to prepare a pyroelectric sensor.

The sensor which had been prepared from each ceramic sample was examined for its pyroelectric characteristics. The results are shown in TABLE 1. Each of Samples Nos. 1 to 11 is a composition of the formula hereinbefore given in which X is 0, i.e. of the formula $Pb_A\{(Zn_{1/3}\bullet Nb_{2/3})_W\bullet Ti_Y\bullet Zr_Z\}O_3$, while each of Samples Nos. 12 to 46 is a composition of the formula in which X is greater than 0. Each of Samples Nos 16, 17 and 44 to 46 is a composition deviating from the scope of this invention. Samples Nos. 16 and 17 are each a composition of the formula in which the sum of W and X is less than 0.05. Sample No. 44 is a

3

composition of the formula in which Z is less than 0.54. Sample No. 45 is a composition of the formula in which Y is less than 0.24. Sample No. 46 is a composition of the formula in which W is less than 0.015.

TABLE 1 also shows the characteristics of a sensor prepared from PZT-4 for the sake of comparison.

As is obvious from TABLE 1, all of the pyroelectric sensors which had been prepared from the ceramic compositions embodying this invention showed better pyroelectric characteristics than the conventionally known PZT-4 pyroelectric sensor and any other sensor prepared from the composition deviating from the scope of this invention. More specifically, the sensors embodying this invention showed a temperature coefficient of pyroelectricity which was higher than $3 \times 10^{-8}$ $C/cm^2 \cdot C$, and a figure of merit which was higher than $0.35 \times 10^{-10}$ $C \bullet cm/J$. These results confirm that the ceramic composition of this invention makes it possible to realize excellent pyroelectric characteristics which no conventionally available material has been able to achieve.

TABLE 1

| Sample No. | Composition | | | | | Additional component / mol % | Dielectric constant $\varepsilon_r$ | Pyroelectric coefficient $P_T$ | Figure of merit |
|---|---|---|---|---|---|---|---|---|---|
| | A | W | X | Y | Z | | | | |
| 1 | 0.990 | 0.180 | 0 | 0.288 | 0.540 | | 300 | 3.57 | 0.41 |
| 2 | 0.990 | 0.180 | 0 | 0.250 | 0.570 | | 275 | 3.27 | 0.41 |
| 3 | 0.990 | 0.100 | 0 | 0.250 | 0.650 | | 245 | 3.02 | 0.43 |
| 4 | 0.990 | 0.060 | 0 | 0.290 | 0.650 | | 260 | 3.17 | 0.42 |
| 5 | 0.990 | 0.060 | 0 | 0.290 | 0.650 | $Li_2O/2$ | 255 | 4.66 | 0.63 |
| 6 | 0.990 | 0.060 | 0 | 0.290 | 0.650 | $Na_2O/2$ | 255 | 4.51 | 0.61 |
| 7 | 0.990 | 0.060 | 0 | 0.290 | 0.650 | $K_2O/0.5$ | 260 | 3.77 | 0.50 |
| 8 | 0.990 | 0.060 | 0 | 0.290 | 0.650 | $Mn_3O_4/1$ | 250 | 4.35 | 0.60 |
| 9 | 0.990 | 0.060 | 0 | 0.290 | 0.650 | $Mn_3O_4/3$ | 245 | 4.33 | 0.61 |
| 10 | 0.990 | 0.060 | 0 | 0.380 | 0.580 | | 335 | 3.79 | 0.39 |
| 11 | 0.990 | 0.130 | 0 | 0.330 | 0.540 | | 325 | 3.77 | 0.40 |
| 12 | 0.990 | 0.135 | 0.045 | 0.240 | 0.580 | | 320 | 3.99 | 0.43 |
| 13 | 0.990 | 0.105 | 0.035 | 0.240 | 0.620 | | 295 | 3.68 | 0.43 |

| Sample No. | Composition | | | | | Additional component / mol % | Dielectric constant $\varepsilon_r$ | Pyroelectric coefficient $P_T$ | Figure of merit |
|---|---|---|---|---|---|---|---|---|---|
| | A | W | X | Y | Z | | | | |
| 14 | 0.990 | 0.06 | 0.02 | 0.240 | 0.680 | | 280 | 3.25 | 0.40 |
| 15 | 0.990 | 0.0375 | 0.0125 | 0.270 | 0.680 | | 290 | 3.03 | 0.36 |
| *16 | 0.990 | 0.03 | 0.01 | 0.340 | 0.620 | | 343 | 2.88 | 0.29 |
| *17 | 0.990 | 0.08 | 0.01 | 0.300 | 0.660 | $Mn_3O_4/3$ | 300 | 2.96 | 0.34 |
| 18 | 0.990 | 0.0375 | 0.0125 | 0.330 | 0.620 | $Li_2O/0.5$ | 340 | 4.83 | 0.49 |
| 19 | 0.990 | 0.0375 | 0.0125 | 0.330 | 0.620 | $Na_2O/1$ | 342 | 5.26 | 0.53 |
| 20 | 0.990 | 0.0375 | 0.0125 | 0.330 | 0.620 | $K_2O/2$ | 344 | 5.79 | 0.58 |
| 21 | 0.990 | 0.0375 | 0.0125 | 0.330 | 0.620 | $Li_2O/0.5$ $Mn_2O_4/3$ | 339 | 6.78 | 0.69 |
| 22 | 0.990 | 0.0375 | 0.0125 | 0.330 | 0.620 | $Li_2O/0.5$ $Na_2O/0.5$ | 341 | 5.34 | 0.54 |
| 23 | 0.990 | 0.0375 | 0.0125 | 0.380 | 0.570 | | 380 | 4.19 | 0.38 |
| 24 | 0.990 | 0.06 | 0.02 | 0.380 | 0.540 | | 395 | 4.47 | 0.39 |
| 25 | 0.990 | 0.06 | 0.02 | 0.300 | 0.620 | | 325 | 7.63 | 0.81 |

- cont d -

| Sample No. | Composition | | | | | Additional component / mol % | Dielectric constant $\varepsilon_r$ | Pyroelectric coefficient $p_T$ | Figure of merit |
|---|---|---|---|---|---|---|---|---|---|
| | A | W | X | Y | Z | | | | |
| 26 | 0.97 | 0.06 | 0.02 | 0.300 | 0.620 | | 340 | 6.80 | 0.69 |
| 27 | 1.01 | 0.06 | 0.02 | 0.300 | 0.620 | | 305 | 8.58 | 0.97 |
| 28 | 1.03 | 0.06 | 0.02 | 0.300 | 0.620 | | 298 | 6.14 | 0.71 |
| 29 | 1.00 | 0.06 | 0.02 | 0.300 | 0.620 | $Na_2O/1$ $Mn_3O_4/2$ | 310 | 12.59 | 1.40 |
| 30 | 1.00 | 0.06 | 0.02 | 0.300 | 0.620 | $K_2O/2$ $Mn_3O_4/3$ | 290 | 13.37 | 1.59 |
| 31 | 0.990 | 0.065 | 0.065 | 0.300 | 0.570 | | 380 | 7.16 | 0.65 |
| 32 | 0.990 | 0.065 | 0.065 | 0.280 | 0.590 | | 360 | 6.26 | 0.60 |
| 33 | 0.990 | 0.04 | 0.04 | 0.280 | 0.640 | | 340 | 5.13 | 0.52 |
| 34 | 0.990 | 0.03 | 0.03 | 0.30 | 0.640 | | 350 | 4.47 | 0.44 |
| 35 | 0.990 | 0.03 | 0.03 | 0.30 | 0.640 | $Cr_2O_3/3$ | 345 | 5.90 | 0.59 |
| 36 | 0.990 | 0.03 | 0.03 | 0.30 | 0.640 | $K_2O/1$ $Cr_2O_3/1$ | 345 | 6.80 | 0.68 |
| 37 | 0.990 | 0.03 | 0.03 | 0.35 | 0.590 | | 390 | 4.98 | 0.44 |
| 38 | 0.990 | 0.04 | 0.04 | 0.35 | 0.570 | | 400 | 5.34 | 0.46 |

– cont'd –

EP 0 260 875 B1

| Sample No. | Composition | | | | | Additional component / mol % | Dielectric constant $\varepsilon_r$ | Pyroelectric coefficient $P_T$ | Figure of merit |
|---|---|---|---|---|---|---|---|---|---|
| | A | W | X | Y | Z | | | | |
| 39 | 0.990 | 0.03 | 0.09 | 0.30 | 0.580 | | 400 | 5.22 | 0.45 |
| 40 | 0.990 | 0.0225 | 0.0675 | 0.30 | 0.610 | | 385 | 4.91 | 0.44 |
| 41 | 0.990 | 0.015 | 0.045 | 0.33 | 0.61 | | 400 | 4.99 | 0.43 |
| 42 | 0.990 | 0.015 | 0.045 | 0.33 | 0.61 | $Na_2O/0.5$ $Cr_2O_3/0.5$ | 395 | 7.45 | 0.65 |
| 43 | 0.990 | 0.0225 | 0.0675 | 0.33 | 0.58 | | 410 | 5.11 | 0.43 |
| *44 | 0.990 | 0.03 | 0.09 | 0.36 | 0.52 | | 470 | 4.54 | 0.33 |
| *45 | 0.990 | 0.03 | 0.09 | 0.23 | 0.65 | | 340 | 2.81 | 0.28 |
| *46 | 0.990 | 0.01 | 0.09 | 0.31 | 0.59 | | 460 | 4.40 | 0.33 |
| PZT-4 | - | - | - | - | - | - | 1300 | 2.7 | 0.21 |

Notes: (1) $P_T$: $(\times 10^{-8} C/cm^2 \cdot {}^\circ C)$, $P_T/\varepsilon_r \cdot C'$: $(\times 10^{-10} C \cdot cm/J)$

(2) * Composition not according to this invention.

## Claims

1. A ceramic composition for a pyroelectric sensor according to the formula

8

$$Pb_A\{(Zn_{1/3}\bullet Nb_{2/3})_W(Ni_{1/3}\bullet Nb_{2/3})_XTi_YZrZ\}O_3$$

where $0.97 \leq A \leq 1.03$,
$0.015 \leq W \leq 0.18$,
$0 \leq X \leq 0.09$,
$0.05 \leq W + X \leq 0.18$,
$0.24 \leq Y \leq 0.38$,
$0.54 \leq Z \leq 0.68$ and
$W + X + Y + Z = 1$.

2. A ceramic composition for a pyroelectric sensor according to claim 1 said composition containing further a maximum of 2 mol % of at least one of $Li_2O$, $Na_2O$ and $K_2O$.

3. A ceramic composition for a pyroelectric sensor according to claim 1 said composition containing further a maximum of 3 mol % of at least one of $Mn_3O_4$ and $Cr_2O_3$.

4. A ceramic composition for a pyroelectric sensor according to claim 1 said composition containing further a maximum of 2 mol % of at least one of $Li_2O$, $Na_2O$ and $K_2O$ and a maximum of 3 mol % of at least one of $Mn_3O_4$ and $Cr_2O_3$.

5. A ceramic composition as set forth in any of claims 1 to 4, wherein $X = 0$, $0.25 \leq Y \leq 0.38$, and $0.54 \leq Z \leq 0.65$.

6. A ceramic composition as set forth in any of claims 1 to 4, having a temperature coefficient of pyroelectricity which is at least equal to $3 \times 10^{-8}$ $C/cm^2\bullet °C$, and a figure of merit which is at least equal to $0.35 \times 10^{-10}$ $C\bullet cm/J$.

**Revendications**

1. Composition céramique pour un détecteur pyroélectrique répondant à la formule

$$Pb_A\{(Zn_{1/3},Nb_{2/3})_W,(Ni_{1/3},Nb_{2/3})_XTi_YZr_Z)O_3$$

dans laquelle $0,97 \leq A \leq 1,03$,
$0,015 \leq W \leq 0,18$,
$0 \leq X \leq 0,09$,
$0,05 \leq W + X \leq 0,18$,
$0,24 \leq Y \leq 0,38$,
$0,54 \leq Z \leq 0,68$ et
$W + X + Y + Z = 1$.

2. Composition céramique pour un détecteur pyroélectrique suivant la revendication 1, cette composition contenant en outre au maximum 2 % en mole d'au moins l'un de $LiO_2$, $Na_2O$ et $K_2O$.

3. Composition céramique pour un détecteur pyroélectrique suivant la revendication 1, cette composition contenant en outre au maximum 3 % en mole d'au moins l'un de $Mn_3O_4$ et de $Cr_2O_3$.

4. Composition céramique pour un détecteur pyroélectrique suivant la revendication 1, cette composition contenant en outre au maximum 2 % en mole d'au moins l'un de $LiO_2$, $Na_2O$ et $K_2O$ et au maximum 3 % en mole d'au moins l'un de $Mn_3O_4$ et de $Cr_2O_3$.

5. Composition céramique suivant l'une quelconque des revendications 1 à 4, dans laquelle $X = 0,025 \leq Y \leq 0,38$ et $0,54 \leq Z \leq 0,65$.

6. Composition céramique suivant l'une quelconque des revendications 1 à 4, ayant un coefficient de température de pyroélectricité qui est au moins égal à $3 \times 10^{-8}$ $C/cm^2.°C$, et un facteur de qualité qui est au moins égal à $0,35 \times 10^{-10}$ $C.cm/J$.

**Patentansprüche**

1. Eine keramische Zusammensetzung für einen pyroelektrischen Fühler mit der Formel

$$Pb_A \{Zn_{1/3}.(Nb_{2/3})_w.(Ni_{1/3}.Nb_{2/3})_x.Ti_y.Zr_z\}O_3$$

in welcher gilt:
$0,97 \leq A \leq 1,03,$
$0,015 \leq W \leq 0,18,$
$0 \leq X \leq 0,09,$
$0,05 \leq W + X \leq 0,18,$
$0,24 \leq Y \leq 0,38,$
$0,54 \leq Z \leq 0,68$ und
$W + X + Y + Z = 1.$

2. Eine keramische Zusammensetzung für einen pyroelektrischen Fühler nach Anspruch 1, wobei die besagte Zusammensetzung weiterhin maximal 2 mol% mindestens einer der Komponenten $Li_2O$, $Na_2O$ und $K_2O$ enthält.

3. Eine keramische Zusammensetzung für einen pyroelektrischen Fühler nach Anspruch 1, wobei die besagte Zusammensetzung weiterhin maximal 3 mol% mindestens einer der Komponenten $Mn_3$ und $Cr_2O_3$ enthält.

4. Eine keramische Zusammensetzung für einen pyroelektrischen Fühler nach Anspruch 1, wobei die besagte Zusammensetzung weiterhin maximal 2 mol% mindestens einer der Komponenten $Li_2O$, $Na_2O$ und $K_2O$ und maximal 3 mol% mindestens einer der Komponenten $Mn_3O_4$ und $Cr_2O_3$ enthält.

5. Eine keramische Zusammensetzung nach einem der Ansprüche 1 bis 4, in welcher gilt:

$X = 0, 0,25 \leq Y \leq 0,38$ und $0,54 \leq Z \leq 0,65.$

6. Eine keramische Zusammensetzung nach einem der Ansprüche 1 bis 4 mit einem Temperaturkoeffizient der Pyroelektrizität, der mindestens gleich $3 . 10^{-8}$ $C/cm^2 . °C$ ist, und einer Güteziffer, die mindestens gleich $0,35 . 10^{-10}$ $C . cm/_J$ ist.